(19) Europäisches Patentamt / European Patent Office / Office européen des brevets

(11) **EP 4 723 274 A1**

(12) **DEMANDE DE BREVET EUROPEEN**

(43) Date de publication:
**08.04.2026 Bulletin 2026/15**

(21) Numéro de dépôt: **25204658.6**

(22) Date de dépôt: **25.09.2025**

(51) Classification Internationale des Brevets (IPC):
**H01M 10/0525** (2010.01)    **G01R 31/392** (2019.01)
**H01M 10/44** (2006.01)    **H01M 10/48** (2006.01)

(52) Classification Coopérative des Brevets (CPC):
**H01M 10/0525; G01R 31/392; H01M 10/443;**
**H01M 10/48; H01M 10/486**

(84) Etats contractants désignés:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Etats d'extension désignés:
**BA**
Etats de validation désignés:
**GE KH LA MA MD TN**

(30) Priorité: **03.10.2024 FR 2410677**

(71) Demandeur: **Commissariat à l'Energie Atomique**
**et aux Energies**
**Alternatives**
**75015 Paris (FR)**

(72) Inventeurs:
• **DESEURE, Jonathan**
**38054 GRENOBLE CEDEX 09 (FR)**
• **KLEIN, Jean-Marie**
**38054 GRENOBLE CEDEX 09 (FR)**
• **MONTARU, Maxime**
**38054 GRENOBLE CEDEX 09 (FR)**

(74) Mandataire: **Santarelli**
**Tour Trinity**
**1 bis Place de la Défense**
**92400 Courbevoie (FR)**

(54) **DÉTECTION D'UN DÉPÔT DE LITHIUM DANS UNE CELLULE DE BATTERIE LITHIUM-ION**

(57) L'invention concerne une méthode (100) pour détecter un dépôt de lithium sur une électrode négative d'une cellule d'une batterie lithium-ion lors de sa charge. La méthode comporte, pour au moins une phase CC d'un cycle de charge CC-CV de la cellule :
- une collecte (110) d'une pluralité de mesures de température de surface de la cellule,
- une formation (120) d'un signal de température à partir des mesures collectées,
- une décomposition en modes empiriques (130) du signal de température,
- une détermination (150) d'une énergie intrinsèque du signal de température, pour la phase CC considérée, à partir des composantes intrinsèques obtenues par la décomposition en modes empiriques,
- une détermination (160) d'une valeur d'incidence représentative d'un risque de dépôt de lithium en fonction de l'énergie intrinsèque,
- une évaluation (170) d'un critère de détection de dépôt de lithium à partir de la valeur d'incidence.

[Fig. 1]

EP 4 723 274 A1

## Description

### Domaine de l'invention

La présente invention appartient au domaine de la gestion des batteries de type « lithium-ion ». Plus particulièrement, il est proposé une méthode et un système pour détecter la formation d'un dépôt de lithium sur l'électrode négative d'une cellule d'une batterie lithium-ion lors d'une charge de la cellule.

### Etat de la technique

Le dépôt de lithium (« lithium-plating » en anglais) est un phénomène qui peut se produire pendant la charge des batteries lithium-ion, en particulier lorsqu'elles sont chargées rapidement ou à basse température.

Une batterie lithium-ion peut comporter une ou plusieurs cellules. Chaque cellule comporte généralement une électrode négative, une électrode positive, un électrolyte liquide, et un séparateur poreux permettant d'empêcher les électrodes de se toucher. L'électrode positive contient du lithium métallique (par exemple sous forme d'un alliage Lithium-Cobalt-Oxyde pour une batterie de type LCO, un alliage Lithium-Fer-Phosphate pour une batterie de type LFP, ou un alliage de type Nickel-Manganèse-Cobalt pour une batterie de type NMC). L'électrode positive permet de fournir des ions lithium (Li+). Quant à l'électrode négative, elle contient généralement du graphite ou un autre matériau permettant de stocker des ions de lithium. L'emploi de ces matériaux permet « l'intercalation » : les ions de lithium peuvent facilement s'insérer dans les électrodes, ou s'en retirer. Le lithium existe sous forme ionique lorsqu'il est dissous dans l'électrolyte et migre entre les électrodes pendant les cycles de charge et décharge. Durant ces cycles, les ions lithium ne redeviennent normalement pas du lithium métallique ; ils sont simplement incorporés dans les structures cristallines des matériaux d'électrodes lorsqu'ils sont intercalés (insérés) dans les électrodes.

Si le courant de charge est trop élevé, ou si la température de la batterie est trop basse, les ions lithium peuvent ne pas s'intercaler correctement dans l'électrode négative. Au lieu de cela, ils peuvent commencer à se déposer sur la surface de l'électrode négative sous forme de lithium métallique.

Ce phénomène de dépôt de lithium sur l'électrode négative pendant la charge de la batterie peut être dû à plusieurs facteurs. En particulier, un taux de charge trop élevé peut compromettre la capacité de l'électrode négative à intercaler les ions lithium efficacement. En effet, si le courant de charge est trop élevé, cela peut entraîner un potentiel électrochimique trop élevé au niveau de l'électrode négative, qui dépasse alors le potentiel auquel le lithium peut être intercalé dans le matériau de l'électrode de manière stable. Aussi, des températures basses ralentissent la mobilité des ions lithium et la cinétique des réactions.

Ainsi, dans certaines conditions défavorables (charge trop rapide ou températures très basses), les ions lithium se déposent sur l'électrode négative sous forme de lithium métallique pur, au lieu de s'intercaler normalement dans le matériau de l'électrode.

Le dépôt de lithium a plusieurs conséquences négatives pour la batterie. Le lithium qui se dépose sur l'électrode négative ne contribue plus au cycle de charge-décharge de la batterie, ce qui diminue sa capacité globale. L'accumulation de lithium métallique sur l'électrode négative peut augmenter la résistance interne de la batterie, ce qui, à son tour, réduit son efficacité et peut affecter sa performance. Le dépôt irrégulier de lithium peut également endommager l'électrode négative en créant des zones de concentration de stress, et réduire ainsi la durée de vie de la batterie. Enfin, le dépôt de lithium peut prendre la forme de dendrites, des structures métalliques allongées qui peuvent croître au fil du temps jusqu'à percer le séparateur et créer un court-circuit dans la batterie, menant à des problèmes de sécurité (risque d'explosion ou d'incendie).

Pour éviter ou réduire le phénomène de dépôt de lithium dans une batterie, il est important de pouvoir détecter et éventuellement diagnostiquer son apparition. La formation de dépôt de lithium métallique est généralement estimée par des modèles électrochimiques particulièrement complexes qui ne sont pas toujours compatibles avec une détection en temps réel et/ou qui sont difficilement intégrables dans des dispositifs commerciaux de gestion de batterie.

Comme expliqué ci-avant, un dépôt de lithium peut être la cause d'une détérioration d'une cellule de batterie. Dans certains cas, le dépôt de lithium peut également être la conséquence d'une détérioration de la cellule (par exemple une dégradation du matériau formant l'électrode négative peut favoriser le dépôt de lithium). Dans tous les cas, la détection de la formation de dépôt de lithium métallique sur l'électrode négative d'une cellule de batterie permet de détecter une dégradation de cette cellule (diminution de l'état de santé et de la durée de vie de la cellule).

Le document « Detecting undesired lithium plating on anodes for lithium-ion batteries - A review on the in-situ methods », Tian, Y. et al., décrit différentes méthodes pour détecter la formation de dépôt de lithium métallique sur l'anode d'une cellule d'une batterie lithium-ion.

### Exposé de l'invention

La présente invention a pour objectif de remédier à tout ou partie des inconvénients de l'art antérieur, notamment ceux exposés ci-avant, en proposant une solution innovante particulièrement facile à mettre en œuvre, rapide et peu coûteuse en termes de puissance de calcul, pour détecter la formation d'un dépôt de lithium sur une électrode d'une cellule d'une batterie lithium-ion.

A cet effet, et selon un premier aspect, il est proposé une méthode de détection d'un dépôt de lithium sur une électrode négative d'une cellule d'une batterie lithium-ion lors d'une charge de la cellule. La méthode comporte, pour au moins une phase de charge à courant constant, ou phase CC, d'un cycle de charge « courant contant - tension constante », ou cycle de charge CC-CV, de la cellule :

- une collecte d'une pluralité de mesures de température de surface de la cellule à l'aide d'un capteur de température positionné à une surface de la cellule,
- une formation d'un signal de température en normalisant chaque mesure de température de surface de la cellule par rapport à une température d'environnement de la cellule mesurée pendant la phase CC considérée,
- une décomposition en modes empiriques du signal de température afin d'en obtenir une représentation sous la forme d'une somme d'un signal résiduel et d'une ou plusieurs composantes intrinsèques,
- une détermination d'une énergie intrinsèque du signal de température, pour la phase CC considérée, à partir des composantes intrinsèques obtenues par la décomposition en modes empiriques du signal de température,
- une détermination d'une valeur d'incidence représentative d'un risque de dépôt de lithium en fonction de l'énergie intrinsèque,
- une évaluation d'un critère de détection de dépôt de lithium à partir de la valeur d'incidence ainsi déterminée.

Dans des modes particuliers de mise en œuvre, la méthode peut comporter en outre l'une ou plusieurs des caractéristiques suivantes, prises isolément ou selon toutes les combinaisons techniquement possibles.

Dans des modes particuliers de mise en œuvre, la détermination de l'énergie intrinsèque du signal de température pour la phase CC considérée comporte, pour chaque composante intrinsèque obtenue par la décomposition en modes empiriques, un calcul d'une énergie de ladite composante intrinsèque, et l'énergie intrinsèque correspond à une somme des énergies des composantes intrinsèques.

Dans des modes particuliers de mise en œuvre, la valeur d'incidence est déterminée comme étant égale à l'énergie intrinsèque du signal de température, ou à une moyenne glissante de l'énergie intrinsèque pour la phase CC considérée et des énergies intrinsèques déterminées respectivement pour un nombre prédéterminé de phases CC précédentes.

Dans des modes particuliers de mise en œuvre, l'évaluation du critère de détection de dépôt de lithium comporte une comparaison de la valeur d'incidence avec un seuil d'incidence.

Dans des modes particuliers de mise en œuvre, laquelle la valeur d'incidence ou le seuil d'incidence est déterminé(e) en fonction d'une valeur moyenne des énergies intrinsèques déterminées respectivement pour une pluralité de phases CC précédentes pour la cellule.

Dans des modes particuliers de mise en œuvre, la valeur d'incidence ou le seuil d'incidence est déterminé (e) en fonction d'un régime de charge utilisé pour la phase CC considérée et/ou en fonction de la température d'environnement mesurée pour la phase CC considérée.

Dans des modes particuliers de mise en œuvre, la méthode comporte en outre une analyse de fiabilité statistique de la phase CC considérée pour filtrer une phase CC jugée non fiable.

Dans des modes particuliers de mise en œuvre, l'analyse de fiabilité comporte une comparaison du signal résiduel obtenu par la décomposition en modes empiriques du signal de température avec un signal d'interpolation du signal de température.

Dans des modes particuliers de mise en œuvre, la comparaison du signal résiduel avec le signal d'interpolation comporte une comparaison d'un écart quadratique moyen entre le signal résiduel et le signal d'interpolation avec un seuil prédéterminé.

Dans des modes particuliers de mise en œuvre, le signal d'interpolation est obtenu sous la forme d'un polynôme trigonométrique.

Dans des modes particuliers de mise en œuvre, l'analyse de fiabilité comporte, pour chaque composante intrinsèque du signal de température, un calcul d'une entropie de la composante intrinsèque.

Dans des modes particuliers de mise en œuvre, l'analyse de fiabilité comporte un calcul d'une entropie d'une somme des composantes intrinsèques du signal de température.

Dans des modes particuliers de mise en œuvre, l'analyse de fiabilité comporte une comparaison d'une énergie d'une composante intrinsèque du signal de température avec un premier seuil d'énergie ou avec les énergies des autres composantes intrinsèques du signal de température, et/ou une comparaison de l'énergie intrinsèque du signal de température avec un deuxième seuil d'énergie ou avec des énergies intrinsèques déterminées pour des phases CC précédentes.

Dans des modes particuliers de mise en œuvre, lorsqu'un dépôt de lithium est détecté, la méthode comporte une mémorisation d'une occurrence d'une défaillance de la cellule, pour une analyse a posteriori d'un état de santé de la cellule.

Dans des modes particuliers de mise en œuvre, lorsqu'un dépôt de lithium est détecté, la méthode comporte une action corrective relative aux caractéristiques de charge et/ou d'environnement de la batterie. L'action corrective peut par exemple consister à réduire la vitesse de charge, à augmenter la température d'environnement de la batterie, et/ou à interdire la charge endessous d'une certaine température, etc.

Selon un deuxième aspect, la présente invention concerne un système pour détecter un dépôt de lithium sur une électrode négative d'une cellule d'une batterie lithium-ion lors d'une charge de la cellule. Le système comporte :

- un capteur de température destiné à être positionné au niveau d'une surface de la cellule, pour fournir des mesures de température de surface de la cellule,
- un capteur de température destiné à mesurer une température d'environnement de la cellule,
- une unité de calcul configurée pour mettre en œuvre la méthode selon l'un quelconques des modes de mise en œuvre précédents.

**Présentation des figures**

L'invention sera mieux comprise à la lecture de la description suivante, donnée à titre d'exemple nullement limitatif, et faite en se référant aux figures suivantes :

[Fig. 1] une représentation schématique des principales étapes d'un exemple de mise en œuvre de la méthode selon l'invention pour détecter un dépôt de lithium sur l'électrode négative d'une cellule de batterie lithium-ion,
[Fig. 2] une représentation schématique d'un exemple de mise en œuvre de l'étape de formation du signal de température,
[Fig. 3] un graphique représentant l'évolution au cours du temps d'une valeur d'incidence représentative d'un risque de dépôt de lithium pour deux cellules de batterie similaires soumises à des conditions différentes de température et de vitesse de charge,
[Fig. 4] une représentation schématique d'un exemple de mise en œuvre de l'étape d'analyse de fiabilité,
[Fig. 5] à [Fig. 8] des graphiques représentant l'évolution au cours du temps d'une valeur d'incidence représentative d'un risque de dépôt de lithium pour quatre cellules de batterie similaires soumises à des conditions différentes de température et de régime de charge,
[Fig. 9] une représentation schématique d'un système selon l'invention permettant de détecter un dépôt de lithium sur l'électrode négative d'une cellule de batterie lithium-ion.

Dans ces figures, des références identiques d'une figure à une autre désignent des éléments identiques ou analogues. Pour des raisons de clarté, les éléments représentés ne sont pas nécessairement à une même échelle, sauf mention contraire.

**Description détaillée de l'invention**

Un cycle de charge d'une cellule de batterie lithium-ion comporte classiquement deux phases : une première phase de charge à courant constant, ou phase CC (pour « Constant Current » en anglais) et une deuxième phase de charge à tension constante, ou phase CV (pour « Constant Voltage » en anglais). On parle alors d'un cycle de charge CC-CV. Dans la présente invention, on s'intéresse à la « température de peau » de la cellule de la batterie (température mesurée à la surface de la cellule) pendant la phase CC.

Bien que classiquement la première phase de charge (phase CC) s'effectue à courant constant, des schémas de charge plus élaborés peuvent exister durant cette première phase, avec une évolution du courant par exemple pour maximiser la vitesse de charge tout en restant dans le domaine de charge compatible avec l'accumulateur. La fin de la première phase de charge est alors marquée par l'atteinte d'un seuil de tension qui déclenche le basculement dans la seconde phase de charge à tension constante (phase CV). Par simplicité, on considèrera ces cas particuliers de première phase de charge comme également couverts par le vocable CC-CV « courant constant - tension constante » utilisé dans cette demande.

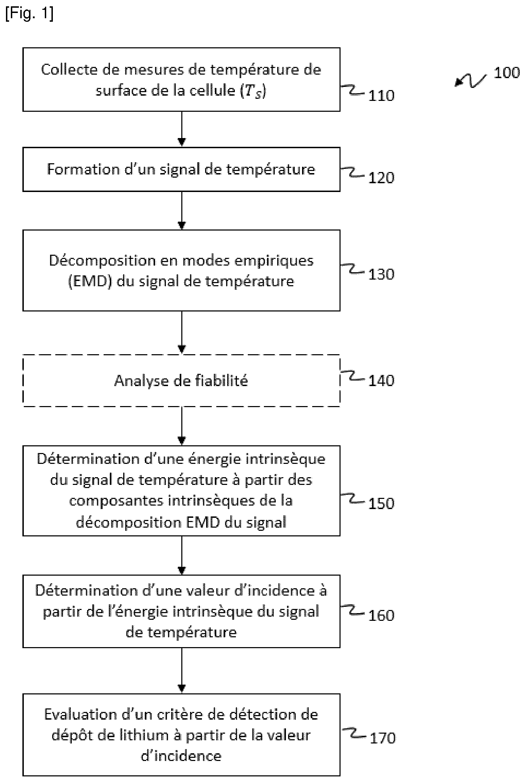

La figure 1 représente schématiquement les principales étapes d'un exemple de mise en œuvre de la méthode selon l'invention pour détecter un dépôt de lithium sur l'électrode négative d'une cellule de batterie lithium-ion.

Tel qu'illustré sur la figure 1, la méthode 100 comporte les étapes suivantes, pour au moins une phase CC) d'un cycle de charge CC-CV de la cellule :

- une collecte 110 d'une pluralité de mesures de température de surface (ou température de peau) de la cellule,
- une formation 120 d'un signal de température en normalisant chaque mesure de température de surface de la cellule par rapport à une température d'environnement de la cellule,
- une décomposition en modes empiriques 130 du signal de température (EMD pour « Empirical Mode Decomposition » en anglais),
- optionnellement, une analyse 140 de fiabilité statistique de la phase CC considérée,
- une détermination 150 d'une énergie intrinsèque du signal de température, pour la phase CC considérée, à partir des composantes intrinsèques obtenues par la décomposition EMD,
- une détermination 160 d'une valeur d'incidence représentative d'un risque de dépôt de lithium en fonction de l'énergie intrinsèque,
- une évaluation 170 d'un critère de détection de dépôt de lithium à partir de la valeur d'incidence.

Comme expliqué précédemment, la formation d'un dépôt de lithium sur l'électrode négative de la cellule est représentative d'une dégradation de la cellule. La méthode 100 proposée permet donc de détecter une dégradation de la cellule : lorsque le critère de détection de dépôt de lithium est satisfait, cela signifie que la cellule a subi une dégradation.

Selon un premier exemple, l'ensemble des étapes de la méthode 100 illustrées sur la figure 1 peuvent être mises en œuvre pour la phase CC de chaque cycle de charge CC-CV subi par la cellule au cours de sa vie, ou pour la phase CC d'un sous-ensemble de la totalité des cycles de charge (par exemple uniquement pour un cycle de charge sur deux, voire à une fréquence inférieure). Un dépôt de lithium peut alors être détecté au moment où le dépôt se produit (en temps réel). Des actions correctives peuvent éventuellement être mises en place pour préserver l'état de santé de la batterie. Par exemple, si c'est possible pour l'usage qui est fait de la batterie, il convient de réduire la vitesse de charge, d'augmenter la température d'environnement de la batterie, ou d'interdire la charge en-dessous d'une certaine température.

Selon un autre exemple, il est envisageable de mémoriser dans un fichier informatique la valeur d'incidence déterminée pour la phase CC de chaque cycle de charge CC-CV subi par la cellule au cours de sa vie, ou pour la phase CC d'un sous-ensemble de la totalité des cycles de charge. La détection de la formation d'un dépôt de lithium peut alors être effectuée a posteriori, à partir des valeurs mémorisées dans le fichier informatique, par exemple pour évaluer un état de santé de la cellule à la fin d'une première vie (par exemple pour décider si la cellule doit être recyclée ou si elle peut être réutilisée en seconde vie, avec une application éventuellement différente). En particulier, les valeurs d'incidence mémorisées dans le fichier informatique peuvent renseigner sur le nombre de cycles de charge de la cellule pour lesquels il y a eu un dépôt de lithium, et sur l'ampleur de ce dépôt. Si une cellule a subi un trop grand nombre de charges avec dépôt de lithium, où s'il y a eu au moins un dépôt de lithium très significatif au cours de la première vie de la batterie, il pourra être décidé que la dégradation de la cellule est trop importante pour envisager un usage en seconde vie.

Au cours de l'étape de collecte 110, les mesures de température de surface de la cellule sont effectuées à l'aide d'un capteur de température positionné au niveau de la surface de la cellule (en contact avec la cellule). De préférence, le capteur de température est positionné à une proximité immédiate de l'électrode négative de la cellule (c'est-à-dire en regard de l'électrode négative), mais un simple positionnement au niveau de la surface de la cellule (c'est-à-dire sur le casing de la cellule) peut suffire. Il peut s'agir par exemple d'un thermocouple ou d'une sonde RTD (pour « Resistance Temperature Detector » en anglais, aussi appelée sonde à résistance de platine). Il peut s'agir d'une sonde de type PTC (pour « Positive Temperature Coefficient », en fançais « coefficient de température positif », c'est une sonde dont la résistance augmente à mesure que sa température augmente) ou de type NTC (pour « Begative Temperature Coefficient », en fançais « coefficient de température négatif », c'est une sonde dont la résistance diminue à mesure que sa température augmente). La méthode est applicable à tout type de sonde de température. On peut par exemple envisager d'utiliser une sonde infrarouge.

Les mesures sont par exemple effectuées avec une fréquence d'acquisition comprise entre cinq et soixante secondes, pendant une durée d'acquisition de vingt à quatre-vingt-dix minutes. Rien n'empêcherait toutefois de faire les mesures avec une fréquence d'acquisition différente, et/ou pendant une durée d'acquisition différente. Il est avantageux d'utiliser un nombre de mesures compris entre quarante et trois-cent par phase CC (utiliser un plus grand nombre de mesures n'implique pas nécessairement une amélioration significative de la méthode, utiliser un nombre de mesures plus faible peut en revanche limiter les performances de la méthode).

Il convient de noter qu'il n'est pas indispensable que la phase CC pendant laquelle les mesures sont effectuées corresponde à une charge complète de la cellule (il peut s'agir d'une charge partielle).

Les mesures ainsi collectées permettent de former (étape 120) un signal de température. Le signal de température est obtenu en normalisant chaque mesure de température de surface ($T_S$) de la cellule par rapport à une température d'environnement ($T_\infty$) de la cellule. Si on note $T_S$ la température de surface, $T_\infty$ la température d'environnement, et $s_k$ une valeur prise par le signal de température, on a :

$$s_k = \frac{T_S}{T_\infty}$$

Les valeurs de températures sont exprimées en degré Kelvin.

La température d'environnement est mesurée à l'aide d'un autre capteur de température située à une distance suffisamment importante de la cellule pour ne pas être impacté par les fluctuations de températures de la cellule. Par exemple, le capteur de température d'environnement peut être situé à au moins quatre fois la hauteur de la cellule lorsque la convection est naturelle, et au moins une fois la hauteur de la cellule si la convection est forcée (ces valeurs peuvent être plus faible si l'on se place dans un fluide avec un nombre de Prandtl supérieur à celui de l'air). La température d'environnement correspond par exemple à une température moyenne de l'environnement de la cellule, mesurée pendant la phase CC considérée. La température d'environnement pourrait toutefois aussi correspondre à une température médiane de l'environnement au cours de la phase CC considérée, ou à une moyenne entre une température maximale et une température minimale de l'environnement mesurées au cours de la phase CC (et d'autres indicateurs de tendance centrale de la température de l'environnement de la cellule pendant la phase CC considérée pourraient être envisagés). Les différentes manières de définir une température d'environnement de la cellule pour une phase CC ne sont que des variantes de l'invention. La température de l'environnement de la cellule peut être mesurée à la même fréquence que la température de surface de la cellule, ou à une fréquence différente.

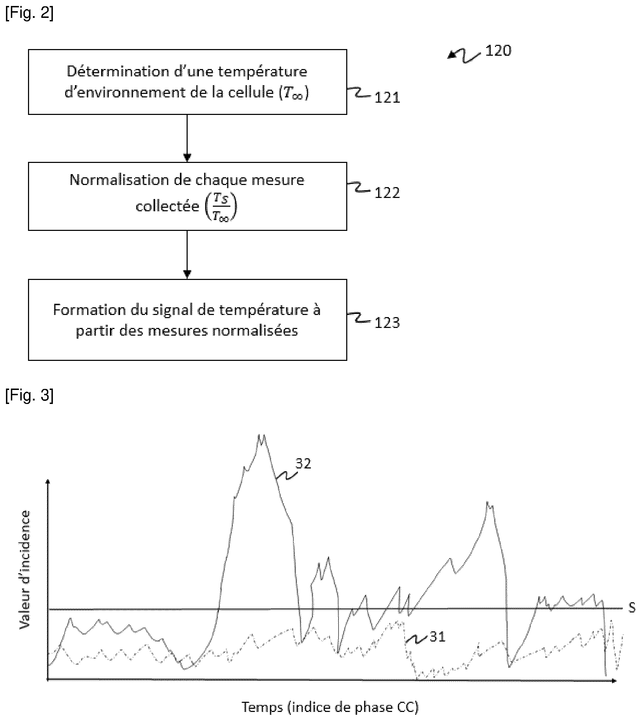

La figure 2 illustre de façon détaillée un exemple de mise en œuvre de la formation 120 du signal de température à partir des mesures de température de surface collectées à l'étape 110. Tel qu'illustré sur la figure 2, l'étape de formation 120 du signal de température comporte une détermination 121 de la température d'environnement $T_\infty$ de la cellule pendant la phase CC considérée, une normalisation 122 de chaque mesure de température de surface $T_S$ collectée pendant la phase CC par rapport à la température d'environnement $T_\infty$, et une formation 123 du signal de température à partir des mesures normalisées $\dfrac{T_S}{T_\infty}$ . Le signal de température représente l'évolution au cours du temps des valeurs normalisées de la température de surface de la cellule pendant la phase CC considérée.

A l'étape 130, le signal de température est décomposé selon une décomposition en modes empiriques (décomposition EMD), afin d'en obtenir une représentation sous la forme d'une somme d'un signal résiduel et d'une ou plusieurs composantes intrinsèques.

La décomposition en modes empiriques consiste à décomposer un signal sous la forme d'une somme de fonctions, de façon similaire à ce que fait la décomposition en série de Fourier ou la décomposition en ondelettes.

Une des particularités de la décomposition en modes empiriques est que la base de fonctions en lesquelles le signal est décomposé n'est pas connue a priori, mais elle est construite de façon adaptative en fonction des propriétés du signal.

La décomposition en modes empiriques correspond à la première partie de la transformée de Hilbert-Huang (HHT pour « Hilbert-Huang Transform » en anglais). La décomposition en modes empiriques consiste à décomposer un signal sous la forme d'une somme d'un signal résiduel et de fonctions de mode intrinsèque (IMF pour « Intrinsic Mode Function » en anglais). Dans la présente demande, ces fonctions de mode intrinsèque sont également appelées « composantes intrinsèques ».

Comme indiqué précédemment, les composantes intrinsèques ne sont pas définies analytiquement. Elles sont plutôt déterminées de façon adaptative en fonction des propriétés du signal.

Une composante intrinsèque (IMF) résultant d'une décomposition en modes empiriques (EMD) doit satisfaire aux exigences suivantes :

- le nombre d'extrema (c'est-à-dire la somme du nombre des maxima locaux et du nombre des minima locaux) et le nombre de passages par zéro de la composante intrinsèque doivent être égaux ou différer au maximum de un ;
- en tout point de la composante intrinsèque, la valeur moyenne de l'enveloppe définie par les maxima locaux et de l'enveloppe définie par les minima locaux est nulle.

Un signal s(t) décomposé par EMD peut alors s'écrire sous la forme :

$$s(t) = r(t) + \sum_{i=1}^{N} c_i(t)$$

Dans cette expression, $r(t)$ correspond au signal résiduel, $N$ est le nombre de composantes intrinsèques de la décomposition EMD, et $c_i$ est la composante intrinsèque d'indice $i$. Chaque composante intrinsèque $c_i(t)$ successive contient des oscillations de fréquence inférieure à celle de la précédente. Le signal résiduel correspond à une tendance générale du signal $s(t)$.

La décomposition en modes empiriques comporte une succession de processus de tamisage (« sifting process » en anglais). Le premier processus de tamisage prend en entrée le signal $s(t)$ directement. Le processus de tamisage correspond à identifier tous les extrema locaux du signal d'entrée, et à relier les maxima locaux, respectivement les minima locaux, par une interpolation par splines cubiques, afin d'obtenir une enveloppe supérieure, respectivement une enveloppe inférieure. Une moyenne entre l'enveloppe supérieure et l'enveloppe inférieure peut alors être calculée et soustraite au signal d'entrée. Si le signal intermédiaire obtenu (soustraction du signal d'entrée avec la moyenne des enveloppes supérieure et inférieure) n'est pas une composante intrinsèque, le processus de tamisage est réitéré sur le signal intermédiaire (qui devient donc le signal d'entrée d'un nouveau processus de tamisage) jusqu'à obtenir une composante intrinsèque. Les processus de tamisage sont répétés jusqu'à obtenir la dernière composante intrinsèque, c'est-à-dire par exemple jusqu'à ce que le signal intermédiaire devienne monotone ou qu'il ne comporte plus qu'un seul extremum local. Le signal restant correspond alors au signal résiduel $r(t)$.

Un critère d'arrêt peut être défini pour le processus de tamisage. Par exemple le critère d'arrêt est satisfait si l'écart-type entre les résultats de deux processus de tamisage successifs est inférieur ou égale à un seuil d'arrêt prédéterminé. Le seuil d'arrêt peut typiquement être compris entre 0.2 et 0.3.

Le document « The empirical mode decomposition and the Hilbert spectrum for non-linear and non-stationary time series analysis », Norden E. Huang et al., Proc. R. Soc. Lond. A (1998) 454, p. 903-995, décrit de façon détaillée la décomposition en modes empiriques, notamment dans ses sections 4 et 5.

Des algorithmes de décomposition en modes empiriques sont disponibles dans des bibliothèques de programmation, par exemple en langage MATLAB ou Python.

Le nombre de composantes intrinsèques obtenues par la décomposition EMD peut varier d'une phase CC à une autre. Le nombre de composantes intrinsèques est généralement inférieur à cinq. Il est avantageux de paramétrer le seuil d'arrêt à un niveau relativement bas, de l'ordre de 0.2, pour extraire un maximum d'information du signal de température. Utiliser un seuil d'arrêt plus faible impose des temps de calcul relativement importants.

Les composantes intrinsèques obtenues à l'étape 130 sont ensuite utilisées pour déterminer une valeur d'incidence représentative d'un risque de dépôt de lithium sur l'électrode négative de la cellule au cours de la phase CC considérée. Cette valeur d'incidence est déterminée en fonction d'une énergie intrinsèque du signal de température.

Tel qu'illustré sur la figure 1, l'énergie intrinsèque du signal de température, pour la phase CC considérée, est déterminée à l'étape 150 à partir des composantes intrinsèques obtenues par la décomposition EMD.

La détermination 150 de l'énergie intrinsèque du signal de température peut notamment comporter, pour chaque composante intrinsèque obtenue par la décomposition EMD, un calcul d'une énergie de la composante intrinsèque. L'énergie intrinsèque du signal de température correspond alors à une somme des énergies des composantes intrinsèques.

L'énergie $E_i$ d'une composante intrinsèque $c_i$ correspond par exemple à l'intégrale du carré de l'amplitude de la composante intrinsèque $c_i$ sur la durée d'acquisition de la phase CC considérée :

$$E_i = \int |c_i(t)|^2 dt$$

L'énergie intrinsèque $E$ du signal de température pour la phase CC considérée peut alors s'écrire sous la forme :

$$E = \sum_{i=1}^{N} E_i$$

Il convient de noter que rien n'empêcherait, dans une variante, de calculer l'énergie intrinsèque E en sommant les énergies d'un sous-ensemble seulement des composantes intrinsèques obtenues par la décomposition EMD (par exemple en considérant seulement un nombre maximum prédéfini des premières composantes intrinsèques obtenues par la décomposition EMD, ou bien, comme on le verra par la suite, en filtrant certaines composantes intrinsèques qui seraient considérées aberrantes). Rien n'empêcherait non plus de définir l'énergie d'une composante intrinsèque de façon différente. Le choix d'une méthode particulière de détermination de l'énergie intrinsèque du signal de température n'est qu'une variante de l'invention.

La valeur d'incidence peut alors être déterminée, à l'étape 160 de la figure 1, comme étant égale à l'énergie intrinsèque du signal de température. Selon un autre exemple, la valeur d'incidence peut correspondre à une moyenne glissante de l'énergie intrinsèque pour la phase CC considérée et des énergies intrinsèques déterminées respectivement pour un nombre prédéterminé de phases CC précédentes.

Par exemple, la valeur d'incidence $\varphi_k$ pour une phase CC d'indice $k$ peut correspondre à l'énergie intrinsèque $E_k$ calculée pour cette phase CC d'indice $k$ :

$$\varphi_k = E_k$$

Selon un autre exemple, la valeur d'incidence $\varphi_k$ peut correspondre à la moyenne glissante des énergies intrinsèques $E_k$, $E_{k-1}$ et $E_{k-2}$ des trois phases CC d'indice $k$, $k - 1$ et $k - 2$ :

$$\varphi_k = \overline{E_{k,3}} = \frac{E_k + E_{k-1} + E_{k-2}}{3}$$

Selon encore un autre exemple, la valeur d'incidence $\varphi_k$ peut être déterminée en fonction d'une valeur moyenne $\bar{E}$ des énergies intrinsèques déterminées respectivement pour une pluralité de phases CC précédentes pour la cellule (par exemple pour toutes les phases CC au cours de la vie de la cellule pour lesquelles l'énergie intrinsèque de la cellule est déterminée, ou bien seulement pour une partie de ces phases CC, par exemple les trente dernières) :

$$\varphi_k = \frac{E_k}{\bar{E}}$$

ou

$$\varphi_k = \frac{\overline{E_{k,3}}}{\bar{E}}$$

avec

$$\bar{E} = \frac{1}{k} \sum_{m=1}^{k} E_m$$

Tel qu'illustré sur la figure 1, la méthode 100 comporte une étape d'évaluation 170 d'un critère de détection de dépôt de lithium en fonction de la valeur d'incidence.

Par exemple, la valeur d'incidence peut être comparée avec un seuil d'incidence, et si la valeur d'incidence dépasse le seuil, alors il est considéré qu'un dépôt de lithium s'est formé sur l'électrode négative de la cellule au cours de la phase CC considérée.

Le seuil d'incidence peut être prédéterminé de façon empirique en laboratoire, par exemple en comparant des valeurs d'incidence avec d'autres mesures issues d'autres méthodes de détection de dépôt de lithium (perte de capacité de la cellule, courant de floating élevé, mesure d'impédance électrochimique anormale, etc.).

Il est également envisageable de déterminer le seuil d'incidence en fonction de la valeur moyenne $\overline{E}$ des énergies intrinsèques déterminées respectivement pour une pluralité de phases CC précédentes. Par exemple, le critère de détection est satisfait si l'énergie intrinsèque $E_k$ (ou la moyenne glissante $\overline{E_{k,3}}$ de l'énergie intrinsèque) est supérieure à cinq fois la valeur moyenne $\overline{E}$ des énergies intrinsèques.

La valeur d'incidence ou le seuil d'incidence peut également être déterminé en fonction d'un régime de charge utilisé pour la phase CC considérée et/ou en fonction de la température d'environnement mesurée pour la phase CC considérée. Le régime de charge peut notamment correspondre à la valeur de courant utilisé pendant la phase CC de la charge. Il est souvent donné en unités de « C », où 1C signifie un courant de charge qui chargerait complètement la cellule en une heure (par exemple un régime de charge de 0,5C pour une cellule de 2Ah correspond à un courant de charge de 1A). Un coefficient correctif qui dépend du régime de charge utilisé et/ou de la température d'environnement peut être appliqué à la valeur d'incidence ou au seuil d'incidence.

Il est envisageable de prendre en compte plusieurs seuils d'incidence permettant de renseigner sur l'ampleur du dépôt de lithium qui a eu lieu pendant la phase CC considéré. Plus le seuil est élevé et plus l'ampleur du dépôt de lithium est importante (et plus la dégradation de la cellule est importante). Le dépassement d'un premier seuil relativement peu élevé peut simplement indiquer un risque de vieillissement accéléré de la cellule, tandis que le dépassement d'un deuxième seuil plus élevé que le premier seuil peut indiquer un risque critique (par exemple un risque d'emballement thermique de la cellule) et la nécessité d'arrêter d'utiliser la cellule.

La figure 3 illustre à titre d'exemple l'évolution au cours du temps d'une valeur d'incidence représentative d'un risque de dépôt de lithium pour deux cellules de batterie similaires soumises à des conditions différentes de température et de vitesse de charge. Lorsque la valeur d'incidence dépasse le seuil d'incidence S, cela signifie qu'un dépôt de lithium a probablement eu lieu au cours de la phase CC correspondante. Une première cellule, représentée par la courbe 31, est soumise à des conditions favorables (température de l'ordre de 20°C, régime de charge de 0,5C). On peut observer sur le graphique de la figure 3 que les valeurs d'incidence de la première cellule restent inférieures au seuil d'incidence S. Une deuxième cellule, représentée par la courbe 32, est soumise à des conditions défavorables (température basse de l'ordre de 0°C, régime de charge élevé à 2C). Les valeurs d'incidence de la deuxième cellule dépassent souvent le seuil d'incidence S, ce qui signifie qu'un dépôt de lithium s'est formé au cours d'un grand nombre de charges de la cellule pendant la période d'observation considérée.

L'intercalation des ions lithium dans les cycles de charge d'une cellule de batterie sont associées à des changements de volume des électrodes de la cellule. Si ces changements de volume n'affectent pas les quantités de chaleur échangées d'un point de vue du transfert thermique, ils impactent en revanche assez significativement les fluctuations thermiques en générant un déplacement de l'électrolyte (mouvement convectif interne) (voir par exemple « Heat Flux and Entropy Produced by Thermal Fluctuations », S. Ciliberto et al.). Le suivi d'une valeur d'incidence représentative de l'énergie intrinsèque du signal de température calculée à partir de la décomposition EMD de ce signal est donc particulièrement adaptée pour détecter des fluctuations thermiques engendrées par les déplacements d'électrolyte liée à une variation de volume de l'électrode négative de la cellule pendant la charge. Cette variation de volume peut être perturbée par la formation de dépôt de lithium métallique sur l'électrode, et c'est pourquoi la méthode proposée permet de détecter une dégradation de la cellule liée à ce dépôt de lithium.

En cas de détection d'un dépôt de lithium, il est envisageable d'enregistrer dans une mémoire l'occurrence d'une dégradation de la cellule, par exemple avec la date et l'heure associée, et éventuellement une information sur l'ampleur du dépôt détecté (qui est représentatif de l'ampleur de la dégradation subie par la cellule). Cela permet, à l'issue d'une période donnée, de faire un bilan du nombre et de l'ampleur des dégradations détectées durant la période considérée, et d'évaluer l'état de la cellule à l'issue de cette période (par exemple en fin d'une première vie de la cellule). Cette évaluation de l'état de la cellule peut par exemple influencer un choix entre un recyclage ou une réutilisation en seconde vie de la cellule.

Comme cela a été mentionné précédemment, une autre option peut être d'enregistrer les valeurs d'incidence dans une mémoire, et de procéder à une détection des dégradations subies par la cellule à l'issue d'une période donnée (a posteriori), à partir des valeurs d'incidence mémorisées. Dans ce cas, l'étape d'évaluation 170 du critère de détection d'un dépôt de lithium n'est pas effectuée à la fin d'une phase CC, mais elle est effectuée à une date ultérieure à partir de la valeur d'incidence mémorisée correspondant à ladite phase CC.

Tel qu'illustré sur la figure 1, la méthode 100 selon l'invention peut également comporter une étape optionnelle d'analyse 140 de la fiabilité statistique d'une phase CC ou d'une composante intrinsèque du signal de température pour la phase CC considérée. Une composante intrinsèque ou une phase CC jugée non fiable peut alors être écartée. Cette étape d'analyse 140 de fiabilité statistique permet notamment d'éviter des faux-positifs (c'est-à-dire éviter d'indiquer à tort une détection de dépôt de lithium).

En particulier, l'étape d'analyse 140 de fiabilité peut comporter une comparaison du signal résiduel r(t) obtenu par la décomposition EMD du signal de température avec un signal d'interpolation f(t) du signal de température. De telles dispositions permettent de s'assurer de la validité de la décomposition EMD.

Le signal d'interpolation peut notamment être obtenu sous la forme d'un polynôme trigonométrique :

$$f(t) = \sum_{i=0}^{N_c} (a_i \cos(iwt) + b_i \sin(iwt))$$

avec

$$w = \frac{2\pi}{L}$$

où L est le nombre de points de mesure d'une phase CC. Les coefficients $a_i$ et $b_i$ sont par exemple obtenus par une méthode de minimisation de distance des moindres carrés par rapport au signal de température $s(t)$. $N_c$ correspond à l'ordre du polynôme trigonométrique, par exemple $N_c$ = 2.

La comparaison du signal résiduel avec le signal d'interpolation peut notamment être effectuée en comparant un écart quadratique moyen (RMSE pour « Root Mean Squared Error » en anglais) entre le signal résiduel et le signal d'interpolation avec un seuil prédéterminé :

$$RMSE = \sqrt{\frac{\sum_{t=0}^{L-1}(r(t) - f(t))^2}{L}}$$

Si l'écart quadratique moyen est supérieur à un seuil (par exemple 3.10^{-3}), alors la décomposition EMD est considérée invalide, et la phase CC correspondante est écartée (c'est-à-dire qu'elle n'est pas prise en compte pour la détection de dépôt de lithium).

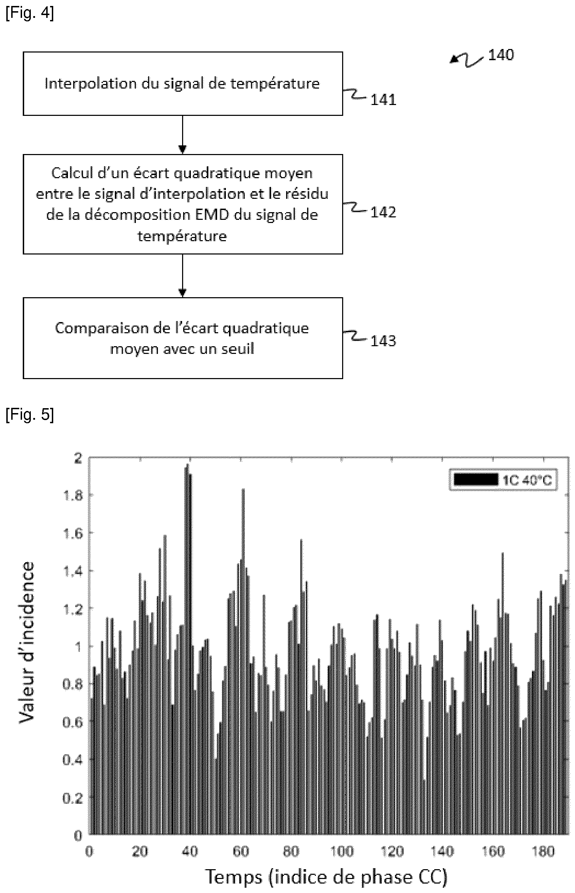

La figure 4 illustre un exemple de mise en œuvre de l'étape d'analyse 140 de fiabilité d'une phase CC. Elle comporte une interpolation 141 du signal de température, un calcul 142 d'un écart quadratique moyen entre le signal d'interpolation et le résidu de la décomposition EMD du signal de température pour la phase CC considérée, et une comparaison 143 de l'écart quadratique moyen avec un seuil prédéterminé.

L'utilisation d'un signal interpolation prenant la forme d'un polynôme trigonométrique est particulièrement avantageuse en termes de temps de calcul. Rien n'empêcherait toutefois d'utiliser un autre type d'interpolation (interpolation polynomiale, polynomiale par morceaux, etc.). Rien n'empêcherait non plus d'utiliser un autre paramètre que l'écart quadratique moyen pour comparer le signal d'interpolation et le signal résiduel (par exemple un écart absolu).

Alternativement, ou en complément, la fiabilité statistique d'une composante intrinsèque ou d'une phase CC peut également être estimée en fonction d'une entropie calculée pour la composante intrinsèque, ou en fonction d'une entropie calculée pour une somme des composantes intrinsèques du signal de température.

Différentes méthodes de calcul d'entropie peuvent être envisagés, comme par exemple un calcul d'entropie de Shannon, ou un calcul d'entropie de Kolmogorov. Par exemple, les phases CC pour lesquelles l'entropie calculée est trop faible (inférieure à un seuil prédéterminé) sont filtrées. Un seuil d'entropie de Shannon compris entre 0.25 et 0.5 peut notamment être envisagé. Lorsque l'entropie des composantes intrinsèques est trop faible, il n'est pas possible de distinguer des fluctuations dynamiques du signal avec le bruit de fond. Le signal de température n'est alors pas exploitable pour la détection de dépôt de lithium.

Alternativement, ou en complément, la fiabilité statistique d'une composante intrinsèque ou d'une phase CC peut également être estimée par des tests statistiques (test de Peirce, test de Chauvenet, test de Grubbs, etc.) portant sur l'énergie de chaque composante intrinsèque du signal de température et/ou sur l'énergie intrinsèque du signal de température.

En particulier, l'analyse 140 de fiabilité peut comporter une comparaison de l'énergie d'une composante intrinsèque du signal de température avec un seuil ou avec les énergies des autres composantes intrinsèques du signal de température. Par exemple, les composantes intrinsèques qui présentent un niveau trop élevé sont jugées aberrantes et elles sont écartées.

L'analyse 140 de fiabilité peut également comporter une comparaison de l'énergie intrinsèque du signal de température avec un seuil ou avec des énergies intrinsèques déterminées pour des phases CC précédentes. Les phases CC qui présentent une énergie intrinsèque aberrante sont écartées.

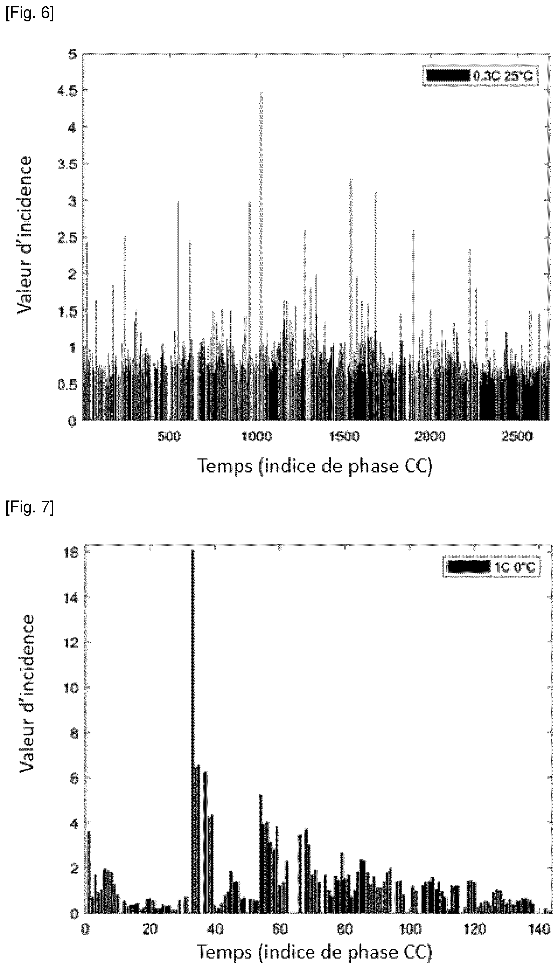

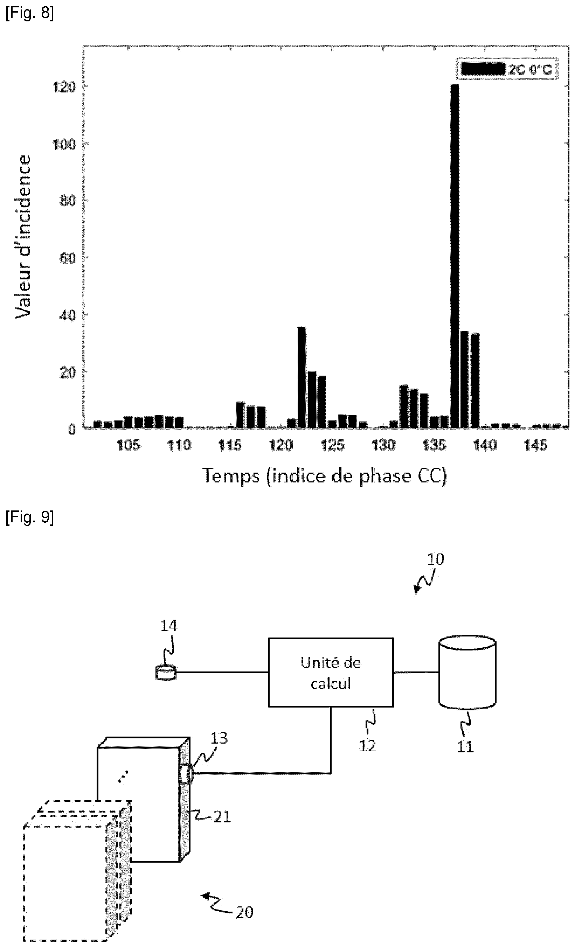

Les figures 5 à 8 sont des graphiques représentant l'évolution au cours du temps d'une valeur d'incidence représentative d'un risque de dépôt de lithium pour quatre cellules similaires soumises à des conditions différentes de température et de régime de charge. Le graphique de la figure 5 correspond à une cellule soumise à une température d'environnement élevée de 40°C et des cycles de charge avec un régime de charge 1C. Le graphique de la figure 6 correspond à une cellule soumise à une température d'environnement modérée de 25°C et des cycles de charge avec un régime de charge 0,3C. Le graphique de la figure 7 correspond à une cellule soumise à une température d'environnement basse de 0°C et des cycles de charge avec un régime de charge 1C. Le graphique de la figure 8 correspond à une cellule soumise à une température d'environnement basse de 0°C et des cycles de charge avec un régime de charge 2C.

Pour les exemples illustrés aux figures 5 à 8, la valeur d'incidence $\varphi_k$ est calculée sous la forme :

$$\varphi_k = \frac{\overline{E_{k,3}}}{\overline{E}}$$

Autrement dit la valeur d'incidence est un ratio entre une moyenne glissante des énergies intrinsèques des trois dernières phases CC par rapport à une moyenne des énergies intrinsèques de l'ensemble des phases CC précédentes.

Lorsque $\varphi_k > 5$ (premier seuil d'incidence égal à cinq), on considère qu'un dépôt de lithium susceptible de causer un vieillissement accéléré de la cellule a eu lieu au cours de la phase CC considérée. Lorsque $\varphi_k > 50$ (deuxième seuil d'incidence égal à cinquante), on considère qu'un dépôt de lithium susceptible de causer un risque critique (emballement thermique, explosion) a eu lieu au cours de la phase CC considérée.

Il apparaît bien sur les graphiques des figures 5 à 8 qu'une température basse et une vitesse de charge rapide (régime de charge élevé) sont des facteurs favorables au dépôt de lithium métallique. En particulier, on peut observer sur les graphiques des figures 5 et 6 que la valeur d'incidence reste toujours sous le premier seuil d'incidence (ces graphiques correspondent à des conditions de température modérée ou chaude, avec une vitesse de charge raisonnable). En revanche, on peut observer sur le graphique de la figure 7 que la valeur d'incidence dépasse relativement souvent le premier seuil d'incidence (ce graphique correspond à une température basse mais une vitesse de charge modérée). Sur le graphique de la figure 8, on peut observer que la valeur d'incidence prend des valeurs particulièrement élevées, et qu'elle dépasse le deuxième seuil d'incidence lors d'une charge (ce graphique correspond à une température basse et une vitesse de charge rapide). Pour la cellule de la figure 8, une rupture du boîtier de la cellule (casing) a été observé peu après le dépassement du deuxième seuil d'incidence.

La figure 9 représente schématiquement un exemple de réalisation d'un système 10 permettant de détecter un dépôt de lithium sur l'électrode négative d'une cellule 21 d'une batterie 20 lithium-ion.

Le système 10 comporte notamment un capteur 13 de température destiné à être positionné à la surface de la cellule 21, de préférence au niveau de l'électrode négative de la cellule 21, pour fournir des mesures de température de surface (température de peau, $T_S$) de la cellule.

Le système 10 comporte également un capteur 14 de température destiné à mesurer une température d'environnement ($T_\infty$) de la cellule 21 (température de l'environnement dans lequel se trouve la cellule).

Le système 10 comporte également une unité 12 de calcul configurée pour mettre en œuvre la méthode 100 selon l'un quelconques des modes de mise en œuvre décrits ci-avant.

Le système 10 peut également comporter un mémoire 11 informatique pour mémoriser les valeurs d'incidence (ou les mesures permettant de calculer ces valeurs d'incidence) pour une pluralité de charges de la cellule au cours de la vie de la cellule.

La communication entre les capteurs 13, 14 et l'unité 12 de calcul (pour la transmission des mesures de température) peut être mise en œuvre par des moyens de communication filaires ou par des moyens de communication sans fil.

La mémoire 11, l'unité de calcul 12 et les capteurs 13 et 14 peuvent faire partie d'un système de gestion de batterie (BMS pour « Battery Management System » en anglais). Selon un autre exemple, l'unité 12 de calcul peut appartenir à un serveur distant auquel sont transmises les mesures de température.

La description ci-avant illustre clairement que, par ses différentes caractéristiques et leurs avantages, la présente invention atteint les objectifs fixés. En particulier, le suivi de l'énergie intrinsèque du signal de température, calculée à partir de la décomposition EMD du signal, est particulièrement bien adaptée pour détecter la formation de dépôt de lithium métallique sur l'électrode négative de la cellule, et donc pour détecter une dégradation de la cellule. Cette détection peut être effectuée en temps réel, pour prendre le cas échéant des mesures correctives visant à optimiser la durée de vie de la cellule, ou bien a posteriori, à la fin d'une première vie de la cellule, pour évaluer la pertinence de réutiliser la cellule dans une deuxième vie. La solution proposée est relativement facile à mettre en œuvre, rapide et peu coûteuse en termes de puissance de calcul. Elle peut notamment facilement être intégrée dans un système de gestion de batterie.

**Revendications**

1. Méthode (100) de détection d'un dépôt de lithium sur une électrode négative d'une cellule (21) d'une batterie (20) lithium-ion lors d'une charge de la cellule (21), la méthode (100) comportant, pour au moins une phase de charge à courant constant, ou phase CC, d'un cycle de charge « courant contant - tension constante », ou cycle de charge CC-CV, de la cellule (21) :

   - une collecte (110) d'une pluralité de mesures de température de surface de la cellule à l'aide d'un capteur de température positionné à une surface de la cellule (21),
   - une formation (120) d'un signal de température en normalisant chaque mesure de température de surface de la cellule (21) par rapport à une température d'environnement de la cellule (21) mesurée pendant la phase CC considérée,
   - une décomposition en modes empiriques (130) du signal de température afin d'en obtenir une représentation sous la forme d'une somme d'un signal résiduel et d'une ou plusieurs composantes intrinsèques,
   - une détermination (150) d'une énergie intrinsèque du signal de température, pour la phase CC considérée, à partir des composantes intrinsèques obtenues par la décomposition en modes empiriques (130) du signal de température,
- une détermination (160) d'une valeur d'incidence représentative d'un risque de dépôt de lithium en fonction de l'énergie intrinsèque,
- une évaluation (170) d'un critère de détection de dépôt de lithium à partir de la valeur d'incidence ainsi déterminée.

2. Méthode (100) selon la revendication 1 dans laquelle la détermination (150) de l'énergie intrinsèque du signal de température pour la phase CC considérée comporte, pour chaque composante intrinsèque obtenue par la décomposition en modes empiriques (130), un calcul d'une énergie de ladite composante intrinsèque, et l'énergie intrinsèque correspond à une somme des énergies des composantes intrinsèques.

3. Méthode (100) selon l'une quelconque des revendications 1 à 2 dans laquelle la valeur d'incidence est déterminée comme étant égale à l'énergie intrinsèque du signal de température, ou à une moyenne glissante de l'énergie intrinsèque pour la phase CC considérée et des énergies intrinsèques déterminées respectivement pour un nombre prédéterminé de phases CC précédentes.

4. Méthode (100) selon l'une quelconque des revendications 1 à 3 dans laquelle l'évaluation (170) du critère de détection de dépôt de lithium comporte une comparaison de la valeur d'incidence avec un seuil d'incidence.

5. Méthode (100) selon la revendication 4 dans laquelle la valeur d'incidence ou le seuil d'incidence est déterminé en fonction d'une valeur moyenne des énergies intrinsèques déterminées respectivement pour une pluralité de phases CC précédentes pour la cellule (21).

6. Méthode (100) selon l'une quelconque des revendications 4 à 5 dans laquelle la valeur d'incidence ou le seuil d'incidence est déterminé en fonction d'un régime de charge utilisé pour la phase CC considérée et/ou en fonction de la température d'environnement mesurée pour la phase CC considérée.

7. Méthode (100) selon l'une quelconque des revendications 1 à 6 comportant en outre une analyse (140) de fiabilité statistique de la phase CC considérée pour filtrer une phase CC jugée non fiable.

8. Méthode (100) selon la revendication 7 dans laquelle l'analyse (140) de fiabilité comporte une comparaison du signal résiduel obtenu par la décomposition en modes empiriques (130) du signal de température avec un signal d'interpolation du signal de température.

9. Méthode (100) selon la revendication 8 dans laquelle la comparaison du signal résiduel avec le signal d'interpolation comporte une comparaison d'un écart quadratique moyen entre le signal résiduel et le signal d'interpolation avec un seuil prédéterminé.

10. Méthode (100) selon l'une quelconque des revendications 7 à 9 dans laquelle l'analyse (140) de fiabilité comporte, pour chaque composante intrinsèque du signal de température, un calcul d'une entropie de la composante intrinsèque.

11. Méthode (100) selon l'une quelconque des revendications 7 à 10 dans laquelle l'analyse (140) de fiabilité comporte un calcul d'une entropie d'une somme des composantes intrinsèques du signal de température.

12. Méthode (100) selon l'une quelconque des revendications 7 à 11 dans laquelle l'analyse (140) de fiabilité comporte une comparaison d'une énergie d'une composante intrinsèque du signal de température avec un premier seuil d'énergie ou avec les énergies des autres composantes intrinsèques du signal de température, et/ou une comparaison de l'énergie intrinsèque du signal de température avec un deuxième seuil d'énergie ou avec des énergies intrinsèques déterminées pour des phases CC précédentes.

13. Méthode (100) selon l'une quelconque des revendications 1 à 12 dans laquelle, lorsqu'un dépôt de lithium est détecté, la méthode (100) comporte une mémorisation d'une occurrence d'une défaillance de la cellule (21), pour une analyse a posteriori d'un état de santé de la cellule (21).

14. Méthode (100) selon l'une quelconque des revendications 1 à 13 dans laquelle, lorsqu'un dépôt de lithium est détecté, la méthode (100) comporte une action corrective relative aux caractéristiques de charge et/ou d'environnement de la batterie.

15. Système (10) pour détecter un dépôt de lithium sur une électrode négative d'une cellule (21) d'une batterie (20) lithium-ion lors d'une charge de la cellule (21), ledit système (10) comportant :

- un capteur (13) de température destiné à être positionné au niveau d'une surface de la cellule (21), pour fournir des mesures de température de surface de la cellule,
- un capteur (14) de température destiné à mesurer une température d'environnement de la cellule (21),
- une unité (12) de calcul configurée pour mettre en œuvre la méthode (100) selon l'une quelconques des revendications 1 à 13.

[Fig. 1]

```
┌─────────────────────────────────────┐
│ Collecte de mesures de température de│  ⌇ 110        ⤸ 100
│      surface de la cellule (T_S)     │
└─────────────────────────────────────┘
                    │
                    ▼
┌─────────────────────────────────────┐
│  Formation d'un signal de température│  ⌇ 120
└─────────────────────────────────────┘
                    │
                    ▼
┌─────────────────────────────────────┐
│   Décomposition en modes empiriques  │  ⌇ 130
│     (EMD) du signal de température    │
└─────────────────────────────────────┘
                    │
                    ▼
┌ ─ ─ ─ ─ ─ ─ ─ ─ ─ ─ ─ ─ ─ ─ ─ ─ ─ ─ ┐
│          Analyse de fiabilité         │  ⌇ 140
└ ─ ─ ─ ─ ─ ─ ─ ─ ─ ─ ─ ─ ─ ─ ─ ─ ─ ─ ┘
                    │
                    ▼
┌─────────────────────────────────────┐
│  Détermination d'une énergie intrinsèque│
│  du signal de température à partir des  │  ⌇ 150
│     composantes intrinsèques de la      │
│     décomposition EMD du signal         │
└─────────────────────────────────────┘
                    │
                    ▼
┌─────────────────────────────────────┐
│  Détermination d'une valeur d'incidence à│
│  partir de l'énergie intrinsèque du signal│  ⌇ 160
│            de température             │
└─────────────────────────────────────┘
                    │
                    ▼
┌─────────────────────────────────────┐
│  Evaluation d'un critère de détection de│
│  dépôt de lithium à partir de la valeur │  ⌇ 170
│              d'incidence              │
└─────────────────────────────────────┘
```

[Fig. 2]

```
                                                              ⟋ 120
┌─────────────────────────────────┐
│   Détermination d'une température │
│   d'environnement de la cellule (T∞)│ ⟋ 121
└─────────────────────────────────┘
                 │
                 ▼
┌─────────────────────────────────┐
│   Normalisation de chaque mesure │
│   collectée (Ts/T∞)              │ ⟋ 122
└─────────────────────────────────┘
                 │
                 ▼
┌─────────────────────────────────┐
│   Formation du signal de température à│
│   partir des mesures normalisées │ ⟋ 123
└─────────────────────────────────┘
```

[Fig. 3]

[Fig. 4]

140

Interpolation du signal de température — 141

Calcul d'un écart quadratique moyen entre le signal d'interpolation et le résidu de la décomposition EMD du signal de température — 142

Comparaison de l'écart quadratique moyen avec un seuil — 143

[Fig. 5]

[Fig. 6]

[Fig. 7]

[Fig. 8]

[Fig. 9]

Europäisches
Patentamt

European
Patent Office

Office européen
des brevets

## RAPPORT DE RECHERCHE EUROPEENNE

Numéro de la demande

EP 25 20 4658

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | CN 116 626 509 A (ZHONGXINHANG TECHNOLOGY CO LTD) 22 août 2023 (2023-08-22) * alinéas [0001], [0003], [0013], [0028] - [0043], [0106] - [0108] * * figure 1 * ----- | 1-15 | INV. H01M10/0525 G01R31/392 H01M10/44 H01M10/48 |
| A | WO 2024/004716 A1 (DENSO CORP [JP]) 4 janvier 2024 (2024-01-04) * le document en entier * -& EP 4 549 969 A1 (DENSO CORP [JP]) 7 mai 2025 (2025-05-07) * alinéas [0007], [0018], [0019], [0025] - [0028], [0031], [0032], [0054] * ----- | 1-15 | |
| A | TIAN YU ET AL: "Detecting undesired lithium plating on anodes for lithium-ion batteries - A review on the in-situ methods", APPLIED ENERGY, ELSEVIER SCIENCE PUBLISHERS, GB, vol. 300, 13 juillet 2021 (2021-07-13), XP086732412, ISSN: 0306-2619, DOI: 10.1016/J.APENERGY.2021.117386 [extrait le 2021-07-13] * abrégé * * figure 11 * ----- -/-- | 1-15 | DOMAINES TECHNIQUES RECHERCHES (IPC) H01M G01R |

Le présent rapport a été établi pour toutes les revendications

| Lieu de la recherche | Date d'achèvement de la recherche | Examinateur |
|---|---|---|
| La Haye | 20 janvier 2026 | Grave, Christian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

Europäisches
Patentamt

European
Patent Office

Office européen
des brevets

## RAPPORT DE RECHERCHE EUROPEENNE

Numéro de la demande

EP 25 20 4658

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | KHALEGHI SAHAR ET AL: "Towards machine-learning driven prognostics and health management of Li-ion batteries. A comprehensive review", RENEWABLE AND SUSTAINABLE ENERGY REVIEWS, ELSEVIERS SCIENCE, NEW YORK, NY, US, vol. 192, 21 décembre 2023 (2023-12-21), XP087532239, ISSN: 1364-0321, DOI: 10.1016/J.RSER.2023.114224 [extrait le 2023-12-21] * abrégé * * section 4.1 : Filtering * ----- | 1-15 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| La Haye | 20 janvier 2026 | Grave, Christian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 ...........................................................................................

& : membre de la même famille, document correspondant

EPO FORM 1503 03.82 (P04C02)

page 2 de 2

**ANNEXE AU RAPPORT DE RECHERCHE EUROPEENNE
RELATIF A LA DEMANDE DE BREVET EUROPEEN NO.**

EP 25 20 4658

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-01-2026

| Document brevet cité au rapport de recherche | Date de publication | Membre(s) de la famille de brevet(s) | Date de publication |
|---|---|---|---|
| CN 116626509    A | 22-08-2023 | AUCUN | |
| WO 2024004716    A1 | 04-01-2024 | CN     119487405 A | 18-02-2025 |
| | | EP      4549969 A1 | 07-05-2025 |
| | | JP      7639782 B2 | 05-03-2025 |
| | | JP     2024004844 A | 17-01-2024 |
| | | KR   20250028437 A | 28-02-2025 |
| | | US     2025130287 A1 | 24-04-2025 |
| | | WO     2024004716 A1 | 04-01-2024 |
| EP 4549969    A1 | 07-05-2025 | CN     119487405 A | 18-02-2025 |
| | | EP      4549969 A1 | 07-05-2025 |
| | | JP      7639782 B2 | 05-03-2025 |
| | | JP     2024004844 A | 17-01-2024 |
| | | KR   20250028437 A | 28-02-2025 |
| | | US     2025130287 A1 | 24-04-2025 |
| | | WO     2024004716 A1 | 04-01-2024 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **TIAN, Y**. Detecting undesired lithium plating on anodes for lithium-ion batteries. *A review on the in-situ methods*

- **NORDEN E. HUANG et al.** The empirical mode decomposition and the Hilbert spectrum for non-linear and non-stationary time series analysis. *Proc. R. Soc. Lond. A*, 1998, vol. 454, 903-995
- **S. CILIBERTO**. *Heat Flux and Entropy Produced by Thermal Fluctuations*